(19) **Europäisches Patentamt**
**European Patent Office**
**Office européen des brevets**

(11) Numéro de publication : **0 125 154**
**B1**

(12) **FASCICULE DE BREVET EUROPÉEN**

(45) Date de publication du fascicule du brevet :
30.09.87

(51) Int. Cl.⁴ : **G 11 C 11/14, G 11 C 19/08**

(21) Numéro de dépôt : **84400655.1**

(22) Date de dépôt : **02.04.84**

(54) **Mémoire à bulles magnétiques.**

(30) Priorité : 08.04.83 FR 8305791

(43) Date de publication de la demande :
14.11.84 Bulletin 84/46

(45) Mention de la délivrance du brevet :
30.09.87 Bulletin 87/40

(84) Etats contractants désignés :
DE GB NL

(56) Documents cités :
FR-A- 2 189 839
US-A- 3 678 479
US-A- 4 012 724
AIP CONFERENCE PROCEEDINGS ON MAGNETISM
& MAGNETIC MATERIALS, no. 24, 3-6 décembre
1974, T.J. WALSH et al.: "Novel bubble drive", pages
550-551.

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Fedeli, Jean-Marc**
**Beauséjour - Le Fontanil Cornillon**
**F-38120 Saint Egreve (FR)**
Inventeur : **Jouve, Hubert**
**Domaine des Plantées**
**F-38330 Biviers (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention concerne une mémoire à bulles magnétiques. Elle s'applique à la mémorisation d'informations binaires matérialisées sous la forme de domaines magnétiques isolés, qualifiés de bulles dans une couche d'un grenat magnétique. Ces domaines présentent une aimantation inverse de celle du grenat magnétique.

Chaque bulle peut être déplacée par une force et le mouvement de la bulle peut s'effectuer librement dans n'importe quelle direction, dans le plan de la couche de grenat magnétique. Les bulles sont formées dans la couche de grenat en lui appliquant un champ magnétique continu perpendiculaire au plan de cette couche. Ce champ est produit dans la pratique par un aimant permanent ; il assure la non-volatilité des informations contenues dans la mémoire. La couche de grenat magnétique dans laquelle sont formées les bulles, est généralement supportée par un grenat monocristallin magnétique.

Il est connu de déplacer des bulles contenues dans le grenat magnétique, au moyen de feuilles ou bandes conductrices parcourues par des courants et présentant des fenêtres permettant de fixer le parcours des bulles dans ce grenat. Ces feuilles sont électriquement isolées entre elles et électriquement isolées du grenat. Il est également connu de déplacer les bulles dans le grenat au moyen d'un champ magnétique tournant, ces bulles étant guidées le long des frontières de motifs définis par des zones d'implantation ionique de ce grenat. Dans les deux cas, les bulles se déplacent comme dans un registre à décalage ; l'information que constitue la bulle se décale à chaque tour du champ magnétique tournant ou à chaque cycle d'impulsions de courant dans les feuilles ou bandes conductrices. Cette organisation en registre à décalage est la plus utilisée. La lecture d'une information contenue dans la mémoire nécessite un nombre de décalages qui dépend du nombre de cases que cette information doit parcourir dans le registre à décalage, pour aller de la case dans laquelle elle est contenue, jusqu'à l'extrémité du registre. Cette organisation nécessite donc un temps d'accès très important et l'accès est alors dit « séquentiel » puisque l'accès à l'information est un accès série, qui nécessite des séquences, soit de rotations d'un champ tournant, soit d'impulsions dans des feuilles perforées parcourues par un courant. C'est précisément le cas de la mémoire décrite dans le brevet US-A-4 012 724, sur lequel est basé le préambule de la revendication 1.

L'invention vise plus précisément des mémoires à bulles dans lesquelles les bulles sont déplacées grâce à des courants parcourant des feuilles conductrices perforées. Généralement, le type de mémoire présente (de façon connue) deux feuilles conductrices percées de fenêtres. Ces feuilles sont parallèles entre elles, et sont parcourues par des courants qui sont eux aussi parallèles. Les bulles peuvent être transférées entre deux cellules de mémoires repérées par des fenêtres, par un déplacement perpendiculaire aux courants parcourant chacune des bandes dans lesquelles sont réalisées ces fenêtres. Les bulles peuvent aussi être déplacées entre deux cellules de mémoires repérées par des fenêtres, grâce à des courants parallèles à la direction de déplacement des bulles. Les courants sont néanmoins parallèles entre eux dans les deux feuilles, pour des déplacements parallèles ou perpendiculaires aux courants. Une mémoire connue de ce type est décrite dans le brevet, US n° 4 314 358. Dans la mémoire décrite dans ce brevet les feuilles conductrices superposées sont respectivement parcourues par des courants parallèles et les déplacements des bulles dans la mémoire sont perpendiculaires à la direction de ces courants, pour les registres mineurs ou de mémorisation, tandis que ces déplacements dans le registre majeur ou d'accès, sont parallèles à ces courants.

Ce type connu de mémoire à bulles, dans lequel les feuilles conductrices sont parcourues par des courants parallèles a pour principal inconvénient de ne permettre qu'une organisation de la mémoire en registres mineurs ou de mémorisation et en registre majeur ou d'accès, l'accès à l'information dans la mémoire ne pouvant être que séquentiel. Il est impossible avec ce type de mémoire, d'accéder directement, dans une première phase, à une matrice de cellules de cette mémoire, puis, d'accéder ensuite dans une seconde phase, à chacune des cellules de cette matrice, de manière séquentielle, pour réaliser ainsi un accès pseudo-aléatoire. Ce type de mémoire a aussi pour inconvénient de rendre impossible un accès aléatoire aux cellules de cette mémoire, pour modifier les informations qu'elles contiennent, par simple modification des sens des courants circulant dans les feuilles conductrices, sans nécessiter des actions séquentielles. L'invention a pour but de remédier à ces inconvénients en réalisant une mémoire à bulles simple dans laquelle l'accès peut être soit pseudo-aléatoire, soit aléatoire. Ces buts sont atteints grâce à l'utilisation de bandes conductrices disposées perpendiculairement et dans lesquelles circulent respectivement des courants perpendiculaires.

L'invention a pour objet une mémoire à bulles magnétiques comprenant une couche d'un grenat magnétique dans laquelle peuvent être formées des bulles magnétiques localisées respectivement par des cellules, chaque cellule comprenant une paire de fenêtres de localisation découpées respectivement dans des bandes conductrices d'une paire de bandes conductrices, ces bandes étant isolées entre elles et isolées du grenat et étant aptes à être parcourues respectivement par des courants de déplacement de la bulle éventuellement localisée dans la cellule, les bandes de la paire de bandes ayant des directions perpendiculaires entre elles, les courants dans ces bandes étant respectivement parallèles à ces directions, les fenêtres de chaque paire étant rectangulaires et perpendiculaires entre elles, caractérisée en ce que l'une des fenêtres présente une portion de surface commune avec l'autre fenêtre, au voisinage de la partie médiane de cette autre fenêtre sans traverser totalement cette fenêtre.

Selon un mode de réalisation particulier, chaque paire de bandes comprend une pluralité de paires de fenêtres de localisation et une pluralité de fenêtres intermédiaires rectangulaires disposées de manière à former une matrice de cellules organisée en au moins un registre mineur ou de mémorisation de bulles ayant une forme bouclée et étant parallèle à l'une des deux directions, et au moins un registre majeur ou d'accès aux bulles mémorisées dans le registre mineur, ce registre majeur ayant une forme bouclée et étant parallèle à l'autre des deux directions, les fenêtres intermédiaires étant séparées des paires de fenêtres de localisation sur les parcours des bulles dans les registres, les déplacements des bulles dans ces registres étant assurés par application des courants de déplacement dans les bandes correspondantes de la paire de bandes considérée, une bulle passant d'un registre mineur à un registre majeur en traversant une ou plusieurs fenêtres intermédiaires, l'accès aux informations contenues dans chaque matrice étant de type pseudo-aléatoire, les moyens de détection de bulles étant constitués par un détecteur situé en regard de l'une des cellules du registre majeur.

Selon un autre mode de réalisation particulier, la mémoire comprend une pluralité de cellules repérées respectivement par lignes et par colonnes, chaque ligne étant formée par une première bande commune à une pluralité de paires de bandes et chaque colonne étant formée par une deuxième bande commune à une pluralité de paires de bandes, les lignes étant parallèles et séparées entre elles, et les colonnes étant parallèles et séparées entre elles, les moyens de détection comprenant un détecteur en regard de chaque cellule et l'accès aux informations contenues dans la mémoire étant de type aléatoire.

Selon encore un autre mode de réalisation particulier, les lignes et les colonnes sont reliées respectivement aux sorties de deux multiplexeurs de sélection de lignes et de colonnes pour sélectionner au moins une bande correspondant à une colonne, pour déplacer une bulle éventuellement présente dans la cellule correspondante par des courants appliqués aux bandes sélectionnées.

Les caractéristiques et avantages de l'invention ressortiront mieux de la description qui va suivre, donnée en référence aux figures annexées dans lesquelles :

la figure 1 représente schématiquement une cellule élémentaire d'une mémoire conforme à l'invention,

la figure 2 représente schématiquement et en vue de dessus, un premier mode de réalisation d'une mémoire à bulles conforme à l'invention, l'accès à cette mémoire étant pseudo-aléatoire,

la figure 3 représente de manière plus détaillée une matrice de cellules de la mémoire à accès pseudo-aléatoire de la figure précédente,

la figure 4 représente schématiquement et en vue de dessus, un deuxième mode de réalisation d'une mémoire conforme à l'invention, l'accès à cette mémoire étant aléatoire.

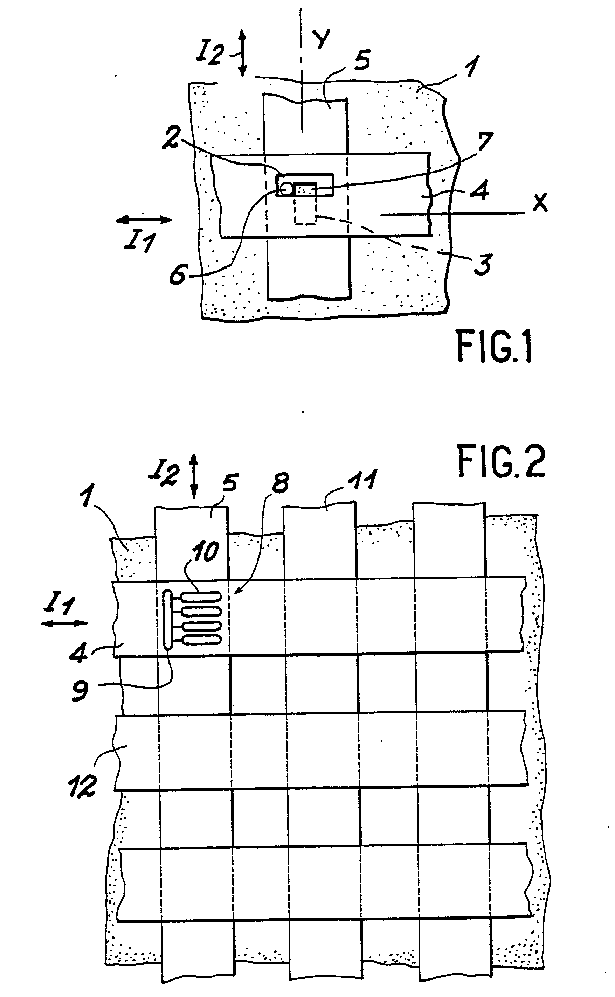

La figure 1 représente schématiquement une cellule élémentaire d'une mémoire à bulles conforme à l'invention. La mémoire qui est constituée d'une pluralité de ces cellules élémentaires, comprend une couche 1 d'un grenat magnétique dans laquelle peuvent être formées des bulles magnétiques localisées par une ou plusieurs des cellules élémentaires. Chaque cellule comprend une paire de fenêtres 2, 3, découpées respectivement dans des bandes conductrices 4, 5, d'une paire de bandes conductrices. Ces bandes sont isolées entre elles et sont isolées du grenat magnétique 1. Elles sont aptes à être parcourues respectivement par des courants $I_1$, $I_2$ pour déplacer la bulle 6 éventuellement localisée dans la cellule.

Selon l'invention, ces bandes présentent respectivement des directions X, Y, perpendiculaires entre elles et les courants $I_1$, $I_2$ circulant respectivement dans ces bandes, sont parallèles aux directions X, Y. Les courants $I_1$, $I_2$ sont impulsionnels et peuvent circuler dans ces bandes, soit dans un sens, soit dans un autre, de manière à déplacer la bulle 6 qui est située par exemple sur la partie gauche de la fenêtre 2, pour l'amener en regard de la fenêtre 3, puis enfin pour l'amener sur la partie droite de la fenêtre 2. Les fenêtres 2, 3, de chaque paire de fenêtres sont rectangulaires et sont perpendiculaires entre elles ; l'une des fenêtres présente une portion de surface 7 commune avec l'autre fenêtre, au voisinage de la partie médiane de cette autre fenêtre. On n'a pas représenté sur cette figure le substrat sur lequel peut être déposée la couche 1 de grenat magnétique. Bien entendu, les bulles sont formées dans le grenat, par application d'un champ magnétique constant et perpendiculaire au plan de cette couche de grenat.

La figure 2 représente schématiquement et en vue de dessus, un premier mode de réalisation d'une mémoire à bulles conforme à l'invention. Dans ce mode de réalisation, la mémoire présente une pluralité de paires de bandes ; chaque paire de bandes telles que 4, 5 par exemple, comprend une pluralité de paires de fenêtres de localisation des bulles, et des fenêtres intermédiaires, qui seront décrites plus loin en détail. Ces fenêtres sont disposées de manière à former une matrice 8 de cellules qui sont organisées de manière à former au moins un registre mineur 10 de mémorisation des bulles, et au moins un registre majeur ou d'accès 9 aux bulles mémorisées dans le registre mineur. Il est bien évident que d'autres matrices comparables à la matrice 8 sont formées aux intersections d'autres paires de bandes telles que 4-11 ou 5-12 etc. Les courants circulant dans les bandes de la paire 4-5 par exemple, sont désignés respectivement par $I_1$, $I_2$.

La structure de cette mémoire dans ce premier mode de réalisation présente les avantages d'une structure matricée : chaque matrice est adressée par l'activation de deux courants transverses tels que $I_1$ et $I_2$. L'opérateur peut donc accéder très rapidement à une matrice de cellules grâce à la simple activation de deux courants.

C'est ainsi par exemple que pour une mémoire d'un million d'éléments binaires, découpée en 100 matrices de cellules, l'opérateur accède très rapidement à 10 000 cellules de chaque matrice et, de ce fait, peut acquérir plus rapidement les informations qui l'intéressent dans les cellules de cette matrice. L'accès à chaque matrice est donc de type aléatoire, mais par contre, comme on le verra plus loin en détail, l'accès aux informations dans les cellules de chaque matrice, est de type séquentiel, puisque chacune de ces matrices est organisée en registre majeur-registres mineurs. L'accès à chaque matrice étant aléatoire et l'accès aux cellules d'une matrice étant séquentiel, la mémoire peut être qualifiée, pour ce premier mode de réalisation, de mémoire à accès pseudo-aléatoire.

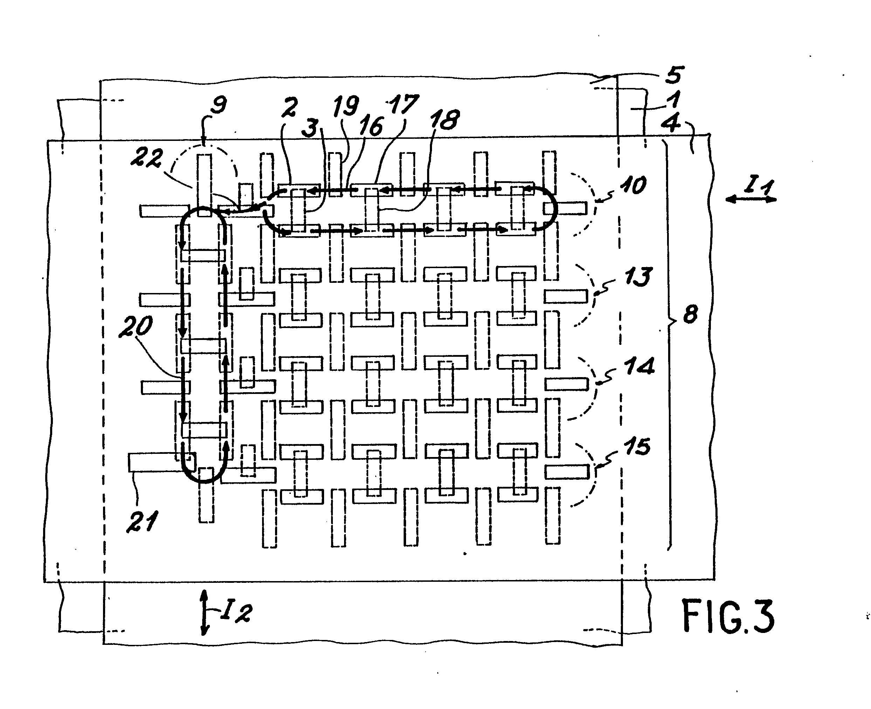

La figure 3 représente de manière plus détaillée l'une des matrices 8 de cellules de mémorisation, dans le premier mode de réalisation de la mémoire de l'invention. Cette matrice comprend, comme on l'a indiqué plus haut, des registres mineurs 10, 13, 14, 15 qui permettent de mémoriser les bulles, et au moins un registre majeur ou d'accès 9. Les parcours des bulles dans les registres mineurs et dans le registre majeur sont représentés schématiquement par des boucles 16, 20. On voit sur cette figure, que le passage d'une bulle d'un registre mineur au registre majeur, se fait sans porte d'accès ; ce passage se fait de plus élément binaire par élément binaire. Dans les registres mineurs, les paires de fenêtres de localisation telles que 2-3 et 17-18, sont séparées par des fenêtres intermédiaires 19 permettant de guider chaque bulle lorsque celle-ci passe d'une cellule à une autre. Chaque extrémité du registre majeur comprend un détecteur de bulles 21. Ce détecteur peut être par exemple une bande d'un alliage de fer et de nickel, isolée des bandes conductrices 4-5. On a également représenté sur cette figure, la couche 1 de grenat magnétique sur laquelle sont disposées les bandes conductrices. Les courants $I_1$, $I_2$ permettent d'accéder à la matrice 8 tandis que l'accès aux bulles contenues dans un registre mineur, tel que 10 par exemple, se fait séquentiellement par l'intermédiaire du registre majeur 9. Les bulles sont détectées à l'extrémité du registre majeur 9, par le détecteur 21. La flèche 22 représente schématiquement le parcours d'une bulle passant du registre mineur 10 au registre majeur 9.

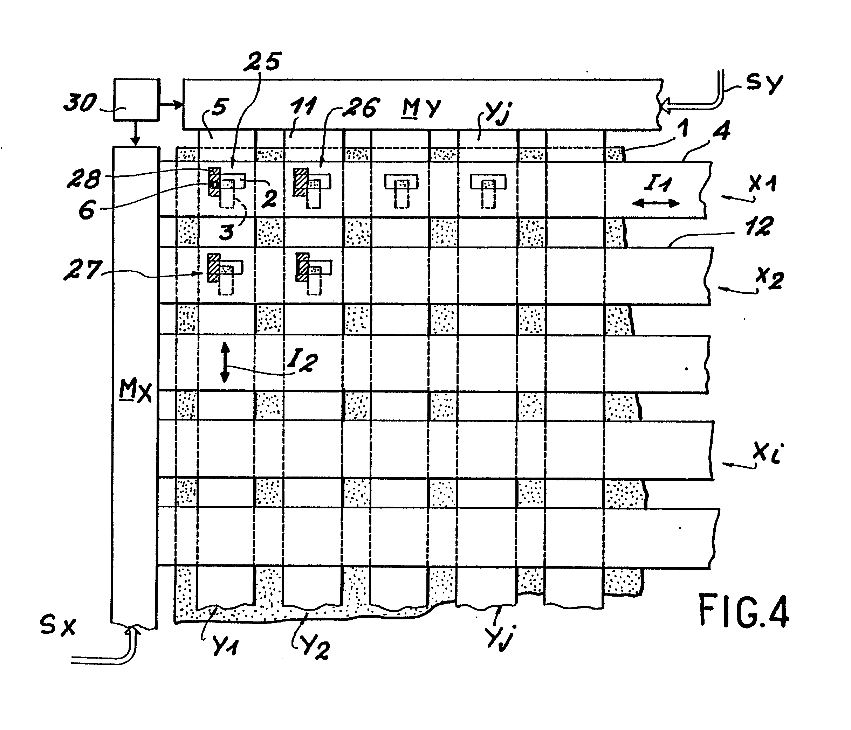

La figure 4 représente schématiquement et en vue de dessus, un deuxième mode de réalisation d'une mémoire conforme à l'invention. Dans ce mode de réalisation, l'accès à la mémoire est totalement aléatoire.

La mémoire comporte, dans ce mode de réalisation, une pluralité de cellules 25, 26, 27 ..., repérées respectivement par les intersections de lignes $X_1$, $X_2$, ..., $X_i$ et de colonnes $Y_1$, $Y_2$, ..., $Y_j$. Chaque ligne $X_i$ est formée par une première bande commune à une pluralité de paires de bandes et chaque colonne est formée par une deuxième bande commune à une pluralité de paires de bandes. C'est ainsi par exemple que la ligne $X_1$ est formée par la première bande 4 des paires de bandes 4-5, 4-11, ... etc, et que la colonne $Y_1$ est formée par la deuxième bande 5 des paires de bandes 5-4, 5-12 ... etc... Chaque cellule de localisation située à l'intersection d'une ligne et d'une colonne comprend, comme l'a indiqué plus haut, deux fenêtres 2, 3 découpées respectivement dans les bandes 4, 5. Les lignes $X_1$, $X_2$, ... $X_i$ sont parallèles et séparées entre elles. Les colonnes $Y_1$, $Y_2$, $Y_j$, sont aussi parallèles et séparées entre elles ; les lignes et les colonnes sont perpendiculaires et sont respectivement reliées aux sorties de deux multiplexeurs MX et MY de sélection de lignes et de colonnes. Ces multiplexeurs permettent de sélectionner au moins une bande correspondant à une ligne et au moins une bande correspondant à une colonne pour déplacer une bulle éventuellement présente dans la cellule correspondant à cette ligne et cette colonne, par des courants appliqués aux bandes sélectionnées. La sélection d'une ligne et d'une colonne est effectuée grâce à des signaux de sélection SX et SY appliqués à des entrées de commande des multiplexeurs MX et MY ; ces multiplexeurs sont alimentés par une source de courant 30 capable de fournir aux multiplexeurs des courants impulsionnels pouvant circuler dans les lignes et les colonnes, dans un sens ou dans un autre. C'est ainsi par exemple, que lorsque l'on veut modifier l'information contenue dans la cellule 25, représentée par la bulle 6, on applique des courants dans les bandes correspondant à la ligne $X_1$ et à la colonne $Y_1$. L'information en mémoire peut être codée de la manière suivante : lorsque la bulle 6 est sur la partie gauche de la fenêtre 2, on peut convenir que la présence de cette bulle à cet emplacement correspondant à un 1 logique, tandis que lorsque la bulle est absente de cet emplacement et qu'elle est située sur la droite de la fenêtre 2 l'information correspond à un 0 logique. L'information en mémoire est lue par des détecteurs de bulles tels que 28 (par exemple une bande d'un alliage de fer et de nickel) qui sont eux aussi repérés par lignes et par colonnes. Ces détecteurs sont connus dans l'état de la technique et ne sont pas décrits ici en détail.

La mémoire qui vient d'être décrite pour ce second mode de réalisation de l'invention, est donc une mémoire à accès aléatoire ; elle présente de plus l'avantage d'être non volatile.

**Revendications**

1. Mémoire à bulles magnétiques comprenant une couche (1) d'un grenat magnétique dans laquelle peuvent être formées des bulles magnétiques localisées respectivement par des cellules, chaque cellule comprenant une paire de fenêtres de localisation (2, 3) découpées respectivement dans des bandes conductrices (4, 5) d'une paire de bandes conductrices, ces bandes étant isolées entre elles et isolées du grenat et étant aptes à être parcourues respectivement par des courants ($I_1$, $I_2$) de déplacement de la bulle éventuellement localisée dans la cellule, les bandes de la paire de bandes ayant des directions (X, Y) perpendiculaires entre elles, les courants ($I_1$, $I_2$) dans ces bandes étant respectivement parallèles à ces directions (X, Y), les fenêtres (2, 3) de chaque paire étant rectangulaires et perpendiculaires entre elles, caractérisée en ce que l'une des fenêtres (3) présente une portion de surface (7) commune avec l'autre fenêtre (2), au voisinage de la partie médiane de cette autre fenêtre (2) sans traverser totalement cette autre fenêtre.

2. Mémoire à bulles, selon la revendication 1, caractérisée en ce que chaque paire de bandes (4-5) comprend une pluralité de paires de fenêtres (2-3, 17-18 ....) de localisation et une pluralité de fenêtres intermédiaires rectangulaires (19) disposées de manière à former une matrice (8) de cellules organisée en au moins un registre mineur (10) ou de mémorisation de bulles ayant une forme bouclée et étant parallèle à l'une des deux directions (X), et au moins un registre majeur (9) ou d'accès aux bulles mémorisées dans le registre mineur, ce registre majeur ayant une forme bouclée et étant parallèle à l'autre des deux directions (Y), les fenêtres intermédiaires (19) étant séparées des paires de fenêtres de localisation (2-3, 17-18 ...) sur les parcours des bulles dans les registres, les déplacements des bulles dans ces registres étant assurés par application des courants de déplacement ($I_1$, $I_2$) dans les bandes correspondantes de la paire de bandes (4, 5) considérées, une bulle passant d'un registre mineur (10 ou 13 ou 14 ...) à un registre majeur (9) en traversant une ou plusieurs fenêtres intermédiaires, l'accès aux informations contenues dans chaque matrice étant de type pseudo-aléatoire, les moyens de détection de bulles étant constitués par un détecteur (21) situé en regard de l'une des cellules du registre majeur.

3. Mémoire à bulles selon la revendication 1, caractérisée en ce qu'elle comprend une pluralité de cellules (25, 26, 27, ...) repérées respectivement par lignes et par colonnes ($X_1$, ... $X_i$, $Y_1$ ... $Y_j$), chaque ligne ($X_1$) étant formée par une première bande commune à une pluralité de paires de bandes (4-5, 4-11) et chaque colonne ($Y_1$) étant formée par une deuxième bande commune à une pluralité de paires de bandes (5-4, 5-12), les lignes ($X_1$, ... $X_i$) étant parallèles et séparées entre elles, et les colonnes ($Y_1$ ... $Y_j$) étant parallèles et séparées entre elles, les moyens de détection comprenant un détecteur (28) en regard de chaque cellule et l'accès aux informations contenues dans la mémoire étant de type aléatoire.

4. Mémoire à bulles selon la revendication 3, caractérisée en ce que les lignes ($X_1$ ... $X_i$) et les colonnes ($Y_1$ ... $Y_j$) sont reliées respectivement aux sorties de deux multiplexeurs (MX, MY) de sélection de lignes et de colonnes pour slectionner au moins une bande (4) correspondant à une ligne ($X_1$) et au moins une bande (5) correspondant à une colonne ($Y_1$), pour déplacer une bulle éventuellement présente dans la cellule correspondante (25) par des courants ($I_1$, $I_2$) appliqués aux bandes sélectionnées.

## Claims

1. Magnetic bubble memory including a layer (1) of a magnetic garnet in which magnetic bubbles can be formed which are respectively located by cells, each cell includ a pair of locating windows (2, 3) respectively cut into conducting strips (4, 5) of a pair of conducting strips, these strips being insulated from each other and insulated from the garnet and being capable of respectively carrying displacement currents ($I_1$, $I_2$) of the bubble possibly located in the cell, the strips of the pair of strips having directions (X, Y) perpendicular to each other, the currents ($I_1$, $I_2$), in these strips being respectively parallel to these directions (X, Y), the windows (2, 3) of each pair being rectangular and perpendicular to each other, characterized in that one of the windows (3) has a section of area (7) common with the other window (2), in the vicinity of the median section of this other window (2) without totally crossing this other window.

2. Bubble memory according to Claim 1, characterized in that each pair of strips (4-5) includes a plurality of pairs of locating windows (2-3, 17-18 ...) and a plurality of intermediate rectangular windows (19) arranged in such a way as to form a matrix (8) of cells organized as at least one bubble storage or minor register (10) having a looped form and being parallel to one of the two directions (X), and at least one major register (9) or register for access to the bubbles stored in the minor register, this major register having a looped form and being parallel to the other of the two directions (Y), the intermediate windows (19) being separated from the pairs of locating windows (2-3, 17-18 ...) over the paths of the bubbles in the registers, the displacements of the bubbles in these registers being provided by the application of displacement currents ($I_1.I_2$) in the corresponding strips of the pair of strips concerned (4, 5), a bubble passing from a minor register (10 or 13 or 14 ...) to a major register (9) by passing through one or more intermediate windows, access to the information contained in each matrix being of pseudo-random type, the means of detection of bubbles being constituted by a detector (21) situated facing one of the cells of the major register.

3. Bubble memory according to Claim 1, characterized in that it includes a plurality of cells (25, 26, 27, ...) respectively referenced by lines and columns ($X_1$, ... $X_i$, $Y_1$, ... $Y_j$), each line ($X_1$) being formed by a first strip common to a plurality of pairs of strips (4-5, 4-11) and each column ($Y_1$) being formed by a second strip common to a plurality of pairs of strips (5-4, 5-12), the lines (X₁, ... X₁) being parallel and separate from each other, and the columns (Y₁, ... Y₁) being parallel and separate from each other, the means of detection including a detector (28) facing each cell and access to the information contained in the memory being of random type.

4. Bubble memory according to Claim 3, characterized in that the lines (X₁, ... X₁) and the columns (Y₁, ... Y₁) are respectively connected to the outputs of two multiplexers (MX, MY) for selecting lines and columns in order to select at least one strip (4) corresponding with a line (X₁) and at least one strip (5) corresponding with a column (Y₁) in order to displace a bubble possibly present in the corresponding cell (25) by currents (I₁, I₂) applied to the selected strips.

**Patentansprüche**

1. Magnetischer Blasenspeicher mit einer Schicht (1) aus einem magnetischen Granat, in der jeweils durch Zellen lokalisierte, magnetische Blasen gebildet werden können, wobei jede Zelle ein Paar von Lokalisierungsfenstern (2, 3), die jeweils in Leitungsbändern (4, 5) eines Paares von Leitungsbändern ausgeschnitten sind, diese Bänder voneinander und von dem Granat isoliert sind und jeweils von Verschiebeströmen (I₁, I₂) für die gegebenenfalls in der Zelle lokalisierte Blase durchfließbar sind, die Bänder des Bandpaares zueinander senkrecht verlaufende Richtungen (X, Y) aufweisen, die Ströme (I₁, I₂) in diesen Bändern jeweils parallel zu diesen Richtungen (X, Y) verlaufen und die Fenster (2, 3) eines jeden Paares rechteckförmig und senkrecht zueinander sind, dadurch gekennzeichnet, daß eines (3) der Fenster einen mit dem anderen Fenster (2) gemeinsamen Oberflächenbereich (7) aufweist, der dem mittleren Abschnitt dieses anderen Fensters (2) benachbart ist, ohne dieses andere Fenster vollständig zu durchqueren.

2. Blasenspeicher nach Anspruch 1, dadurch gekennzeichnet, daß jedes Bandpaar (4, 5) eine Vielzahl von Lokalisierungsfenstern (2-3, 17-18 ...) und eine Vielzahl von rechteckigen Zwischenfenstern (19) aufweist, die derart angeordnet sind, daß eine Matrix (8) von zu wenigstens einem Unterregister (10) oder einem Blasenspeicherregister, welches schleifenförmig ist und parallel zu einer (X) der zwei Achsen verläuft, und wenigstens zu einen Hauptregister (9) oder einem Zugriffsregister zu den gespeicherten Blasen in dem Unterregister organisierten Zellen gebildet wird, daß das Hauptregister die Form einer Schleife besitzt und parallel zu der anderen (Y) der zwei Richtungen verläuft, daß die Zwischenfenster (19) von Paaren von Lokalisierungsfenstern (2-3, 17-18 ...) auf dem Weg der Blasen in den Registern getrennt sind, daß die Verschiebung der Blasen in diesen Registern durch Anlegen von Verschiebeströmen (I₁, I₂) in den entsprechenden Bändern der bezüglichen Bandpaare (4, 5) sichergestellt ist, daß eine Blase von einem Unterregister (10 oder 13 oder 14 ...) zu einem Hauptregister (9) gelangt, indem sie eines oder mehrere Zwischenfenster durchquert, daß der Zugang zu dem in jeder Matrix enthaltenden Informationen von pseudo-zufälliger Art ist, und daß die Mittel zum Erfassen von Blasen von einem Detektor (21) gebildet sind, der sich einer der Zellen des Hauptregisters gegenüberliegend befindet.

3. Blasenspeicher nach Anspruch 1, dadurch gekennzeichnet, daß er eine Vielzahl von Zellen (25, 26, 27, ...) aufweist, die in Zeilen bzw. Spalten (X₁, ... X₁, Y₁, .... Y₁) lokalisiert sind, daß jede Zeile (X₁) von einem ersten Band, welches einer Vielzahl von Bandpaaren (4-5, 4-11) gemeinsam ist, und jede Spalte (Y₁) von einem zweiten Band gebildet ist, welches einer Vielzahl von Bandpaaren (5-4, 5-12) gemeinsam ist, daß die Zeilen (X₁, ... X₁) parallel und voneinander getrennt und die Spalten (Y₁, ... Y₁) parallel und voneinander getrennt sind, und daß die Erfassungsmittel einen Detektor (28) jeder Zelle gegenüberliegend aufweisen und der Zugriff zu den in dem Speicher enthaltenen Informationen von zufälliger Art ist.

4. Blasenspeicher nach Anspruch 3, dadurch gekennzeichnet, daß die Zeilen (X₁, ..., X₁) und die Spalten (Y₁, ..., Y₁) jeweils mit den Ausgängen von zwei Multiplexern (MX, MY) zur Auswahl von Zeilen und Spalten verbunden sind, um zumindest ein einer Zeile (X₁) entsprechendes Band (4) und zumindest ein einer Spalte (Y₁) entsprechendes Band (5) auszuwählen, damit eine gegebenenfalls in der entsprechenden Zelle (25) vorhandene Blase durch an die ausgewählten Bänder angelegte Ströme (I₁, I₂) verschoben werden kann.

FIG.1

FIG.2

FIG.3

0 125 154

FIG.4

0 125 154